# EUROPEAN PATENT APPLICATION

(11) **EP 2 390 934 A2**
(43) Date of publication of application: **30.11.2011**
(21) Application number: 11167746.4
(22) Date of filing: 26.05.2011
(51) Int. Cl.: H01L 33/40, H01L 33/32, H01L 33/00

(54) **Light emitting device and light emitting device package**

(30) Priority: 27.05.2010 US 348970 P; 15.10.2010 KR 20100101109
(71) Applicant: LG Innotek Co., Ltd, Seoul 100-714 (KR)
(72) Inventor: Choi, Kwang Ki, 100-714 Seoul (KR); Lee, Sang Youl, 100-714 Seoul (KR); Song, June O, 100-714 Seoul (KR); Moon, Ji Hyung, 100-714 Seoul (KR); Jung, Se Yeon, 100-714 Seoul (KR); Sung, Tae Yeon, 100-714 Seoul (KR); Jeon, Joon Woo, 130-860 Seoul (KR); Park, Seong Han, 153-829 Seoul (KR)
(74) Representative: Zardi, Marco

(57) **Abstract**

Provided is a light emitting device. The light emitting device (100) includes a light emitting structure layer (135) including a first conductive type semiconductor layer (110), an active layer (120), and a second conductive type semiconductor layer (130), a gallium barrier layer (113) on the light emitting structure layer, and a metal electrode layer (114) on the gallium barrier layer.

## Description

### BACKGROUND

The present disclosure relates to a light emitting device, a method of fabricating the light emitting device, a light emitting device package, and a lighting system.

Group III-V nitride semiconductors are spotlighted as core materials of light emitting diodes (LEDs) or laser diodes (LDs) due to their physical and chemical characteristics. Generally, the group III-V nitride semiconductors are formed of semiconductor materials having a composition formula of InₓAlyGa_{1-x-y}N (0≤x≤1, 0≤y≤1, 0≤x+y≤1).

Such an LED converts electrical signals into light such as infrared rays, ultraviolet rays or visible rays using characteristics of compound semiconductors. In recent, as light efficiency of the LED is increased, the LED is being used in various fields such as display devices and lighting devices.

### SUMMARY

Embodiments provide a light emitting device having a new structure, a method of fabricating the light emitting device, a light emitting device package, and a lighting system.

Embodiments also provide a light emitting device having improved reliability, a method of fabricating the light emitting device, a light emitting device package, and a lighting system.

In one embodiment, a light emitting device comprises: a light emitting structure layer comprising a first conductive type semiconductor layer, an active layer, and a second conductive type semiconductor layer; a gallium barrier layer on the light emitting structure layer; and a metal electrode layer on the gallium barrier layer.

In another embodiment, a light emitting device package comprises: a body; first and second electrode layers disposed on the body; and a light emitting device disposed on the body and electrically connected to the first and second electrode layers, wherein the light emitting device comprises: a light emitting structure layer comprising a first conductive type semiconductor layer, an active layer, and a second conductive type semiconductor layer; a gallium barrier layer on the light emitting structure layer; and a metal electrode layer on the gallium barrier layer.

The details of one or more embodiments are set forth in the accompanying drawings and the description below. Other features will be apparent from the description and drawings, and from the claims.

### BRIEF DESCRIPTION OF THE DRAWINGS

Fig. 1 is a sectional view of a light emitting device according to an embodiment.

Figs. 2 to 13 are views illustrating a process of fabricating a light emitting device according to an embodiment.

Fig. 14 is a sectional view of a light emitting device package comprising the light emitting device according to an embodiment.

Fig. 15 is a view of a backlight unit comprising the light emitting device package according to an embodiment.

Fig. 16 is a perspective view of a lighting unit comprising the light emitting device package according to an embodiment.

### DETAILED DESCRIPTION OF THE EMBODIMENTS

In the descriptions of embodiments, it will be understood that when a layer (or film), a region, a pattern, or a structure is referred to as being 'on' a substrate, a layer (or film), a region, a pad, or patterns, it can be directly on another layer or substrate, or intervening layers may also be present. Further, it will be understood that when a layer is referred to as being 'under' another layer, it can be directly under another layer, and one or more intervening layers may also be present. Further, the reference about 'on' and 'under' each layer will be made on the basis of drawings.

In the drawings, the thickness or size of each layer is exaggerated, omitted, or schematically illustrated for convenience in description and clarity. Also, the size of each element does not entirely reflect an actual size.

Hereinafter, a light emitting device, a method of fabricating the light emitting device, a light emitting device package, and a lighting system will be described with reference to accompanying drawings.

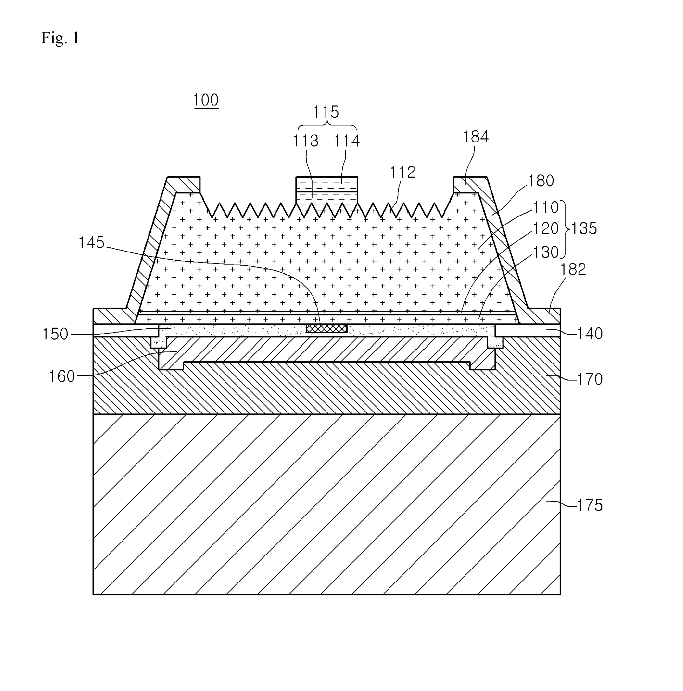

Fig. 1 is a sectional view of a light emitting device 100 according to an embodiment.

Referring to Fig. 1, the light emitting device 100 according to an embodiment may comprise a conductive support member 175, a light emitting structure layer 135 disposed on the conductive support member 175 to generate light and having a light extraction pattern 112 on a portion of a top surface thereof, an electrode 115 disposed on the light emitting structure layer 135 and comprising a gallium barrier layer 113 and a metal electrode layer 114, and a protection layer 180 disposed on top and side surfaces of the light emitting structure layer 135.

A protection member 140, an ohmic layer 150, a reflective layer 160, an adhesion layer 170, and a current blocking layer 145 may be disposed between the conductive support member 175 and the light emitting structure layer 135.

The light emitting structure layer 135 may comprise a first conductive type semiconductor layer 110, an active layer 120, and a second conductive type semiconductor layer 130. Electrons and holes supplied from the first and second conductive type semiconductor layers 110 and 130 may be recombined in the active layer 120 to generate light.

The conductive support member 175 may support the light emitting structure layer 135 and provide a power to the light emitting structure layer 135 together with the electrode 115. For example, the conductive support member 175 may be formed of at least one of Ti, Cr, Ni, Al, Pt, Au, W, Cu, Mo, Cu-W, and a carrier wafer (e.g., Si, Ge, GaN, GaAs, ZnO, SiC, SiGe, or etc) in which impurities are injected. The conductive support member 175 may have a thickness which is varied according to a design of the light emitting device 100. For example, the conductive support member 175 may have a thickness of about 30 µm to about 500 µm.

The adhesion layer 170 may be disposed on the conductive support member 175. The adhesion layer 170 may be a bonding layer and disposed under the reflective layer 160 and the protection member 140. An outer surface of the adhesion layer 170 may be exposed to contact the reflective layer 160, an end of the ohmic layer 150, and the protection member 140, thereby enhancing an adhesion force between the layers.

The adhesion layer 170 may be formed of a barrier metal or bonding metal. For example, the adhesion layer 170 may be formed of at least one of Ti, Au, Sn, Ni, Cr, Ga, In, Bi, Cu, Al, Si, Ag, and Ta.

The reflective layer 160 may be disposed on the adhesion layer 170. The reflective layer 160 may reflect light incident from the light emitting structure layer 135 to improve light emitting efficiency of the light emitting device 100.

The reflective layer 160 may be formed of a metal material having high reflectance, e.g., a metal or alloy comprising at least one of Ag, Ni, Al, Rh, Pd, Ir, Ru, Mg, Zn, Pt, Au, Cu, and Hf. Alternatively, the reflective layer 160 may have a multi layer structure formed using the metal or alloy and transparent conductive material such as IZO, IZTO, IAZO, IGZO, IGTO, AZO, and ATO. For example, the reflection layer 160 may be formed of IZO/Ni, AZO/Ag, IZO/Ag/Ni, AZO/Ag/Ni, Ag/Cu, and Ag/Pd/Cu.

The ohmic layer 150 may be disposed on the reflective layer 160. The ohmic layer 150 may ohmic-contact the second conductive type semiconductor layer 130 to smoothly supply a power to the light emitting structure layer 135.

The ohmic layer 150 may selectively use a transparent conductive layer and a metal. For example, the ohmic layer 150 may be realized as a single or multi layer by using at least one of indium tin oxide (ITO), indium zinc oxide (IZO), indium zinc tin oxide (IZTO), indium aluminum zinc oxide (IAZO), indium gallium zinc oxide (IGZO), indium gallium tin oxide (IGTO), aluminum zinc oxide (AZO), antimony tin oxide (ATO), gallium zinc oxide (GZO), IrOₓ, RuOₓ, RuOₓ/ITO, Ni, Ag, Pt, Ni/IrOₓ/Au, and Ni/IrOₓ/Au/ITO.

The current blocking layer (CBL) 145 may be disposed between the ohmic layer 150 and the second conductive type semiconductor layer 130. At least portion of the CBL 145 may vertically overlap the electrode 115. Thus, a phenomenon in which a current is concentrated into the shortest distance between the electrode 115 and the conductive support member 175 may be reduced to improve light emitting efficiency of the light emitting device 100.

The CBL 145 may be formed of at least one of a material having insulation, a material having conductivity less than that of the reflective layer 160 or the adhesion layer 170, and a material which schottky-contacts a second conductive type semiconductor layer 130. For example, the CBL 145 may be formed of at least one of ITO, IZO, IZTO, IAZO, IGZO, IGTO, AZO, ATO, ZnO, SiO₂, SiOₓ, SiOₓN_{y}, Si₃N₄, Al₂O₃, TiOₓ, TiO₂, Ti, Al, and Cr.

The CBL 145 may be disposed between the reflective layer 160 and the ohmic layer 150, but is not limited thereto.

The protection member 140 may be disposed on a circumference of a top surface of the adhesion layer 170. The protection member 140 may be disposed on a circumference of a bottom surface of the second conductive type semiconductor layer 130. That is, the protection member 140 may have a ring shape, a loop shape, or a frame shape. The protection member 140 may contact the second conductive type semiconductor layer 130 and have a ring shape, a loop shape, or a frame shape within the light emitting device 100.

The protection member 140 may minimize occurrence of an electrical short between the light emitting structure layer 135 and the conductive support member 175. Also, the protection member 140 may prevent moisture from being permeated through a gap between the light emitting structure layer 135 and the conductive support member 175.

The protection member 140 may be formed of at least one of a material having insulation, a material having conductivity less than that of the reflective layer 160 or the adhesion layer 170, and a material which schottky-contacts a second conductive type semiconductor layer 130. For example, the protection member 140 may be formed of at least one of ITO, IZO, IZTO, IAZO, IGZO, IGTO, AZO, ATO, ZnO, SiO₂, SiOₓ, SiOₓN_{y}, Si₃N₄, Al₂O₃, TiOₓ, TiO₂, Ti, Al, and Cr.

The light emitting structure layer 135 may be disposed on the ohmic layer 150 and the protection member 140.

The light emitting structure layer 135 may comprise a plurality of group III-V compound semiconductor layers. For example, the light emitting structure 135 may comprise the first conductive type semiconductor layer 110, the active layer 120 disposed under the first conductive type semiconductor layer 110, and the second conductive type semiconductor layer 130 disposed under the active layer 120.

The first conductive type semiconductor layer 110 may be a group III-V compound semiconductor in which a first conductive type dopant is doped and realized by a formula of InₓAl_{y}Ga_{1-x-y}N (0≤x≤1, 0≤y≤1, 0≤x+y≤1). Also, the first conductive type semiconductor layer 110 may be formed of one of GaN, AlN, AlGaN, InGaN, InN, InAlGaN, AlInN, AlGaAs, GaP, GaAs, GaAsP, and AlGaInP. When the first conductive semiconductor layer 110 is an N-type semiconductor layer, the first conductive type dopant may comprise an N-type dopant such as Si, Ge, Sn, Se, or Te. The first conductive type semiconductor layer 110 may have a single or multi layer structure, but is not limited thereto.

The active layer 120 may be disposed under the first conductive type semiconductor layer 110. The active layer 120 may have one of a single quantum well structure, a multi quantum well (MQW) structure, a quantum wire structure, and a quantum dot structure. For example, the active layer 120 may have a period of a well layer and a barrier layer using a compound semiconductor material of group III-V elements, e.g., a period of an InGaN well layer/a GaN barrier layer or a period of an InGaN well layer/a AlGaN barrier layer.

A conductive type clad layer may be disposed above or/and under the active layer 120. The conductive type clad layer may be formed of an AlGaN-based semiconductor.

The second conductive type semiconductor layer 130 may be disposed under the active layer 120. Also, the second conductive type semiconductor layer 130 may be a group III-V compound semiconductor in which a second conductive type dopant is doped and realized by a formula of InₓAl_{y}Ga_{1-x-y}N (0≤x≤1, 0≤y≤1, 0≤x+y≤1). Also, the second conductive type semiconductor layer 130 may be formed of one of GaN, AlN, AlGaN, InGaN, InN, InAlGaN, AlInN, AlGaAs, GaP, GaAs, GaAsP, and AlGaInP. When the second conductive semiconductor layer 110 is a P-type semiconductor layer, the second conductive type dopant may comprise a P-type dopant such as Mg or Zn.

The light emitting structure layer 135 may further comprise a semiconductor layer having a polarity opposite to that of the second conductive type semiconductor layer 130 under the second conductive type semiconductor layer 130. Also, the first conductive type semiconductor layer 110 may be realized by the P-type semiconductor layer, and the second conductive type semiconductor layer 130 may be realized by the N-type semiconductor layer. Thus, the light emitting structure layer 135 may have at least one structure of an N-P junction structure, a P-N junction structure, an N-P-N junction structure, and a P-N-P junction structure.

The light emitting structure layer 135 may have an inclined side surface by an isolation etching process for dividing a plurality of chips into individual chip units.

Also, the light extraction pattern 112 may be disposed on a top surface of the light emitting structure layer 135. The light extraction pattern 112 may reduce the amount of light in which the light emitted from the light emitting structure layer 135 is totally reflected without being extracted to the outside. Thus, light extraction efficiency of the light emitting device 100 may be improved.

The light extraction pattern 112 and the protection layer 180 may partially vertically overlap each other. Thus, the light extraction efficiency of the light emitting device 100 may be maximized, and it may prevent the protection layer 180 and the first conductive type semiconductor layer 110 from being easily separated from each other. Therefore, reliability of the light emitting device 100 may be improved.

The light extraction patter 112 may have a random shape and arrangement or a desired shape and arrangement.

For example, the light extraction pattern 112 may be arranged with a photonic crystal structure having a period of about 50 nm to about 3,000 nm. The photonic crystal structure may effectively extract light having a specific wavelength to the outside through an interference effect.

Also, the light extraction pattern 112 may have various shapes such as a circular pillar shape, a polygonal pillar shape, a cone shape, a polygonal pyramid shape, a truncated cone shape, and a polygonal cone shape.

The electrode 115 may be disposed on the top surface of the light emitting structure layer 135. The electrode 115 may be branched in a predetermined pattern shape, but is not limited thereto.

The electrode 115 may contact a top surface of the first conductive type semiconductor layer 110. When the first conductive type semiconductor layer 110 is a GaN layer, the electrode 115 may contact the top surface of the first conductive type semiconductor layer 110, i.e., an N-face surface. The electrode 115 may comprise the gallium barrier layer 113 contacting the first conductive type semiconductor layer 110 and the metal electrode layer 114 disposed on the gallium barrier layer 113.

Also, the electrode 115 may have a structure in which at least one pad and an electrode pattern having at least one shape and connected to the pad are equally or differently stacked with each other, but is not limited thereto.

A hole may be defined in the top surface of the first conductive type semiconductor layer 110, i.e., the N-face surface due to diffusion of gallium. Thus, a ratio of N/Ga may be increased to cause non-ohmic contact. Thus, the gallium barrier layer 113 in which gallium is doped may be disposed on the first conductive type semiconductor layer 110 to improve electrical characteristics of the light emitting device 100.

The gallium barrier layer 113 may be formed of a metal in which gallium is doped. The metal may comprise at least one of Al, Ti, Ta, Cr, Mn, V, Nb, Hf, Zr, and Zn. The gallium may be doped into a metal at a concentration of about 1% to about 17% of the total weight ratio of the metal in case where the metal is Al, a concentration of about 1% to about 14% of the total weight ratio of the metal in case where the metal is Ti, a concentration of about 1% to about 14% of the total weight ratio of the metal in case where the metal is Ta, a concentration of about 1% to about 15% of the total weight ratio of the metal in case where the metal is Cr, a concentration of about 1% to about 10% of the total weight ratio of the metal in case where the metal is Mn, a concentration of about 1% to about 15% of the total weight ratio of the metal in case where the metal is V, a concentration of about 1% to about 5% of the total weight ratio of the metal in case where the metal is Nb, a concentration of about 0.3% to about 3% of the total weight ratio of the metal in case where the metal is Hf, a concentration of about 0.2% to about 1% of the total weight ratio of the metal in case where the metal is Zr, and a concentration of about 0.5% to about 4% of the total weight ratio of the metal in case where the metal is Zn.

The metal electrode layer 114 may be formed of at least one of Cr, Ni, Au, Ti, and Al.

The protection layer 180 may be disposed on the top and side surfaces of the light emitting structure layer 135.

The protection layer 180 may prevent the light emitting structure layer 135 from being electrically short-circuited with an external electrode. The protection layer 180 may be formed of a material having insulation and transmittance, e.g., at least one material of SiO₂, SiOₓ, SiOₓN_{y}, Si₃N₄, TiO₂, and Al₂O₃.

The protection layer 180 may be provided in a region above the light emitting structure layer 135 except a region in which the electrode 115 is disposed. Also, the protection layer 180 may be disposed in a region except a region in which the light extraction pattern 112 of the light emitting structure layer 135 is disposed.

The light emitting device 100 according to an embodiment has a vertical type electrode structure. Thus, the light emitting device 100 may be thermally treated only at a low temperature due to characteristics of the device process. For example, when the thermal treatment process is performed at a temperature less than about 250°C, the electrode 115 has a non-ohmic contact characteristic in case where the electrode 115 comprises only the metal electrode layer 114 without comprising the gallium barrier layer 113.

The light emitting device 100 according to an embodiment comprises the gallium barrier layer 113. Thus, it may prevent Ga of the first conductive type semiconductor layer 110 from being diffused, and the ohmic contact may be realized without performing the thermal treatment process at a high temperature.

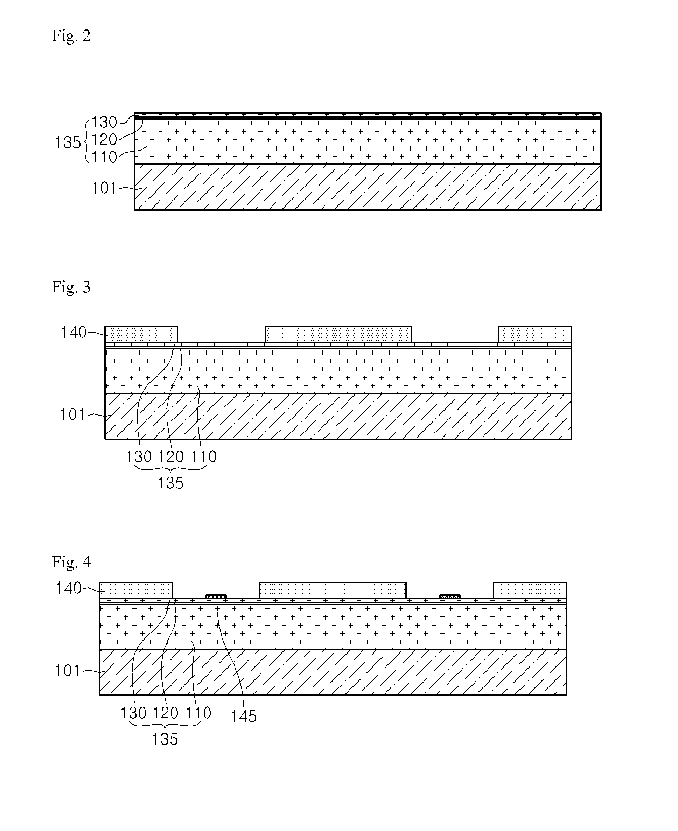

Hereinafter, a method of fabricating a light emitting device 100 according to an embodiment will be described in detail with reference to Figs. 2 to 13. However, descriptions of the construction of the above-described elements will be omitted or briefly described.

Referring to Fig. 2, a light emitting structure layer 135 may be formed on a growth substrate 101.

For example, the growth substrate 101 may be formed of at least one of sapphire (Al₂O₃), SiC, GaN, Si, ZnO, Si, GaP, InP, and Ge, but is not limited thereto.

A first conductive type semiconductor layer 110, an active layer 120, and a second conductive type semiconductor layer 130 may be successively grown on the growth substrate 101 to form the light emitting structure layer 135.

For example, the light emitting structure layer may be formed using a metal organic chemical vapor deposition (MOCVD) process, a chemical vapor deposition (CVD) process, a plasma-enhanced chemical vapor deposition (PECVD) process, a molecular beam epitaxy (MBE) process, or a hydride vapor phase epitaxy (HVPE) process, but is not limited thereto.

A buffer layer may be formed between the light emitting structure layer 135 and the growth substrate 101 1 to reduce a lattice constant difference therebetween.

Referring to Fig. 3, a protection member 140 may be formed along a chip boundary region on the light emitting structure layer 135.

The protection member 140 may be formed on a circumference of an individual chip region using a patterned mask. The protection member 140 may have a ring shape, a loop shape, or a frame shape. For example, the protection member 140 may be formed through an E-beam deposition process, a sputtering process, or a plasma enhanced chemical vapor deposition (PECVD) process.

For example, the protection member 140 may be formed of at least one of ITO, IZO, IZTO, IAZO, IGZO, IGTO, AZO, ATO, ZnO, SiO₂, SiOₓ, SiOₓN_{y}, Si₃N₄, Al₂O₃, TiOₓ, TiO₂, Ti, Al, and Cr.

Referring to Fig. 4, a current blocking layer (CBL) 145 may be formed on the second conductive type semiconductor layer. The CBL 135 may be formed using a patterned mask.

The CBL 135 may be disposed on a position at which at least portion of the CBL 145 vertically overlaps an electrode 115 to be formed later. As a result, a phenomenon in which a current is concentrated into a specific region within the light emitting structure layer 135 may be reduced.

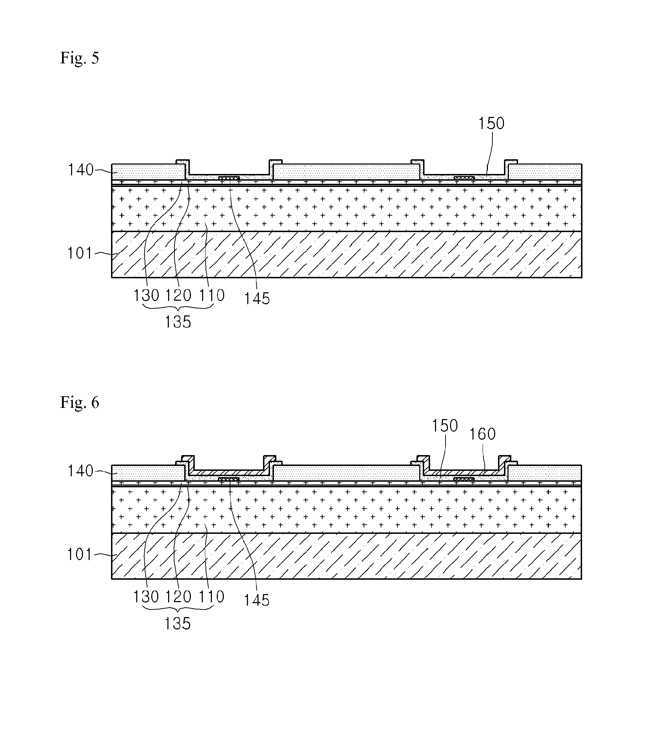

Referring to Figs. 5 and 6, an ohmic layer 150 may be formed on the second conductive type semiconductor layer 130 and the CBL 145. A reflective layer 160 may be formed on the ohmic layer 150.

For example, the ohmic layer 150 and the reflective layer 160 may be formed using one of an E-beam deposition process, a sputtering process, and a plasma enhanced chemical vapor deposition (PECVD) process.

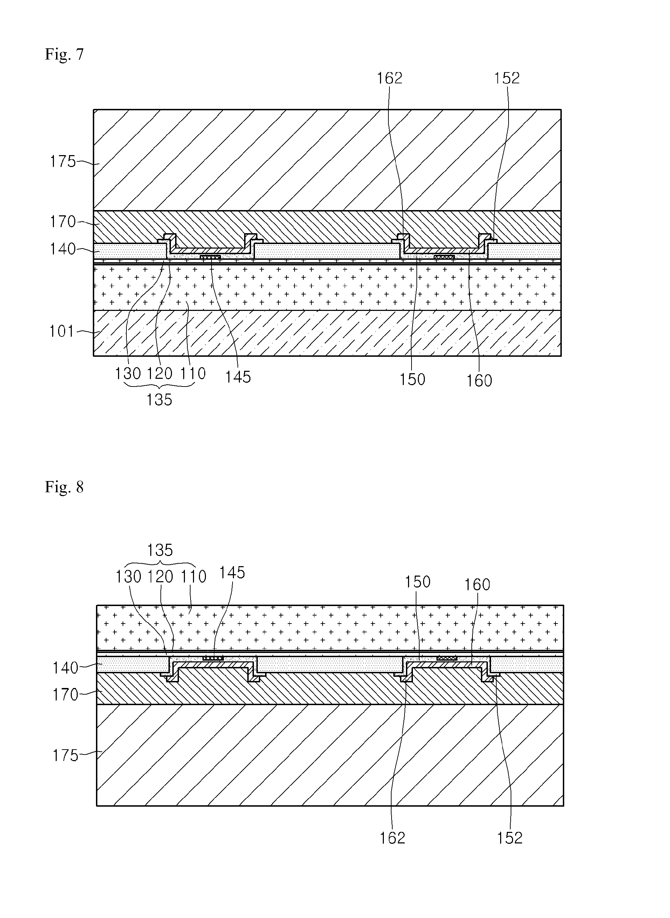

Referring to Fig. 7, an adhesion layer 170 may be formed on the protection member 140. A conductive support member 175 may be formed on the adhesion layer 170.

The adhesion layer 170 may be formed between the protection member 140 and the conductive support member 175 to improve an adhesion force between the layers.

A separate sheet of the conductive support member 175 may be prepared. Then, the separate sheet may be attached on the adhesion layer 170 through a bonding process to form the conductive support member 175. Alternatively, a plating process or a deposition process may be performed to form the conductive support member 175. However, the present disclosure is not limited thereto.

Referring to Figs. 7 and 8, the light emitting device of Fig. 7 may be turned over by 180 degrees, and then, the growth substrate 101 1 may be removed.

The growth substrate 101 may be removed using at least one process of a laser lift off process and an etching process.

Since the growth substrate 101 is removed, a surface of the first conductive type semiconductor layer 110 may be exposed.

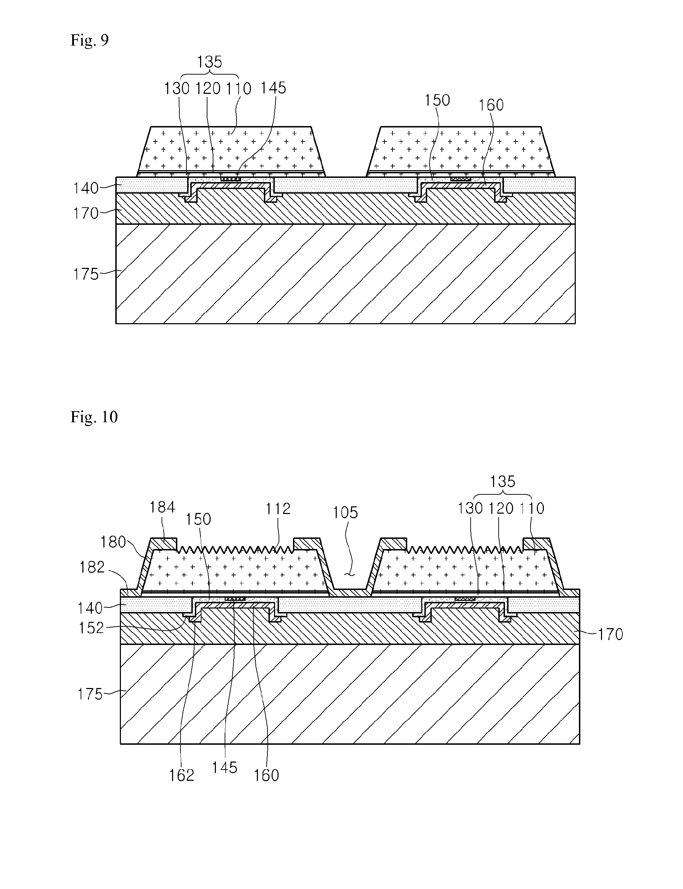

Referring to Fig. 9, an isolation etching process may be performed on the light emitting structure layer 135 along a unit chip region to divide the light emitting structure layer 135 into a plurality of light emitting structure layers 135. For example, the isolation etching process may be performed using dry etching such as inductively coupled plasma (ICP) or wet etching using etchant such as KOH, H₂SO₄, H₃PO₄, but is not limited thereto.

The light emitting structure layer 135 may have an inclined side surface through the isolation etching process as shown in Fig. 9. Also, a portion of a top surface of the protection member 140 may be exposed through the isolation etching process.

Referring to Fig. 10, a light extraction pattern 112 is formed on a top surface of the first conductive type semiconductor layer 110. The light extraction patter 112 may have a random shape and arrangement or a desired shape and arrangement.

A wet etching process may be performed on a top surface of the light emitting structure layer 135 or a physical process such as a polishing process may be performed to form the light extraction pattern 112 having the random shape.

A pattern mask comprising a pattern having a shape corresponding to the desired shape of the light extraction pattern 112 may be formed on the top surface of the first conductive type semiconductor layer 110 and an etching process may be performed along the pattern mask to form the light extraction pattern 112 having the desired shape and arrangement.

A protection layer 180 may be formed on a side surface of the light emitting structure layer 135 and the first conductive type semiconductor layer 110. The protection layer 180 may be formed of a material having insulation and transmittance. The protection layer 180 may comprise oxide material or nitride material, e.g., at least one material of SiO₂, SiOₓ, SiOₓN_{y}, Si₃N₄, TiO₂, and Al₂O₃.

The protection layer 180 may be formed using an E-beam deposition process, a sputtering process, or a plasma enhanced chemical vapor deposition (PECVD) process.

In a method of manufacturing a light emitting device according to another embodiment, the protection layer 180 may be formed, and then the light extraction pattern 112 may be formed.

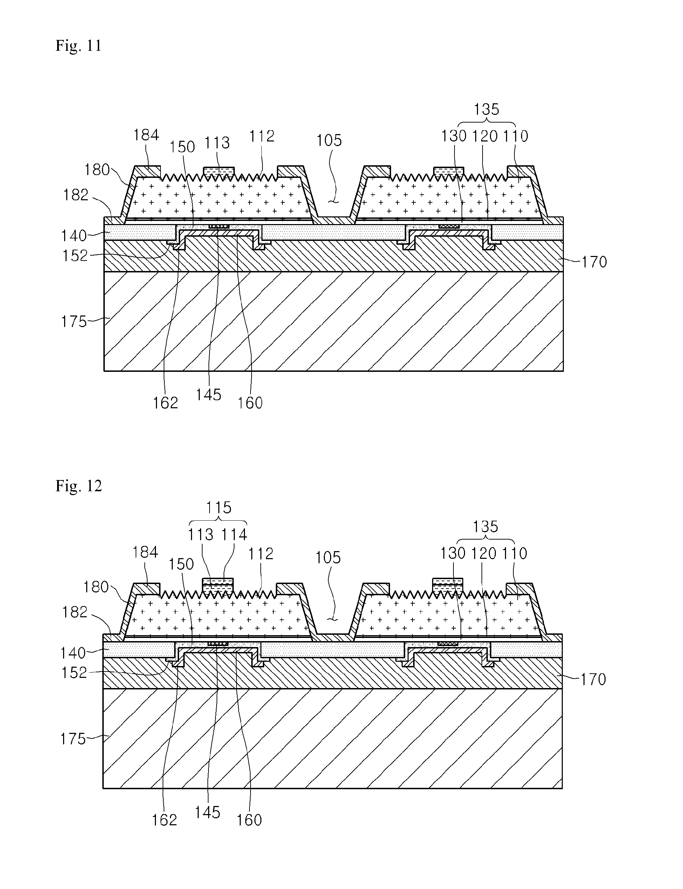

Referring to Fig. 11, a gallium barrier layer 113 may be formed on a portion of the first conductive type semiconductor layer 110. The gallium barrier layer 113 may be formed using a metal in which gallium is doped. The metal may be at least one of Al, Ti, Ta, Cr, Mn, V, Nb, Hf, Zr, and Zn. The gallium may be doped into a metal at a concentration of about 1% to about 17% of the total weight ratio of the metal in case where the metal is Al, a concentration of about 1% to about 14% of the total weight ratio of the metal in case where the metal is Ti, a concentration of about 1% to about 14% of the total weight ratio of the metal in case where the metal is Ta, a concentration of about 1% to about 15% of the total weight ratio of the metal in case where the metal is Cr, a concentration of about 1% to about 10% of the total weight ratio of the metal in case where the metal is Mn, a concentration of about 1% to about 15% of the total weight ratio of the metal in case where the metal is V, a concentration of about 1% to about 5% of the total weight ratio of the metal in case where the metal is Nb, a concentration of about 0.3% to about 3% of the total weight ratio of the metal in case where the metal is Hf, a concentration of about 0.2% to about 1% of the total weight ratio of the metal in case where the metal is Zr, and a concentration of about 0.5% to about 4% of the total weight ratio of the metal in case where the metal is Zn.

Referring to Fig. 12, a metal electrode layer 114 may be formed on the gallium barrier layer 113. The metal electrode layer 114 may be formed of a metal, e.g., at least one of Cr, Ni, Au, Ti, and Al.

The gallium barrier layer 113 and the metal electrode layer 114 may be formed using an E-beam deposition process, a physical vapor deposition (PVD) process, a chemical vapor deposition (CVD) process, a plasma laser deposition process, a dual-type thermal evaporator, or a sputtering process.

The electrode 115 comprising the gallium barrier layer 113 and the metal electrode layer may supply a power into the light emitting structure 135.

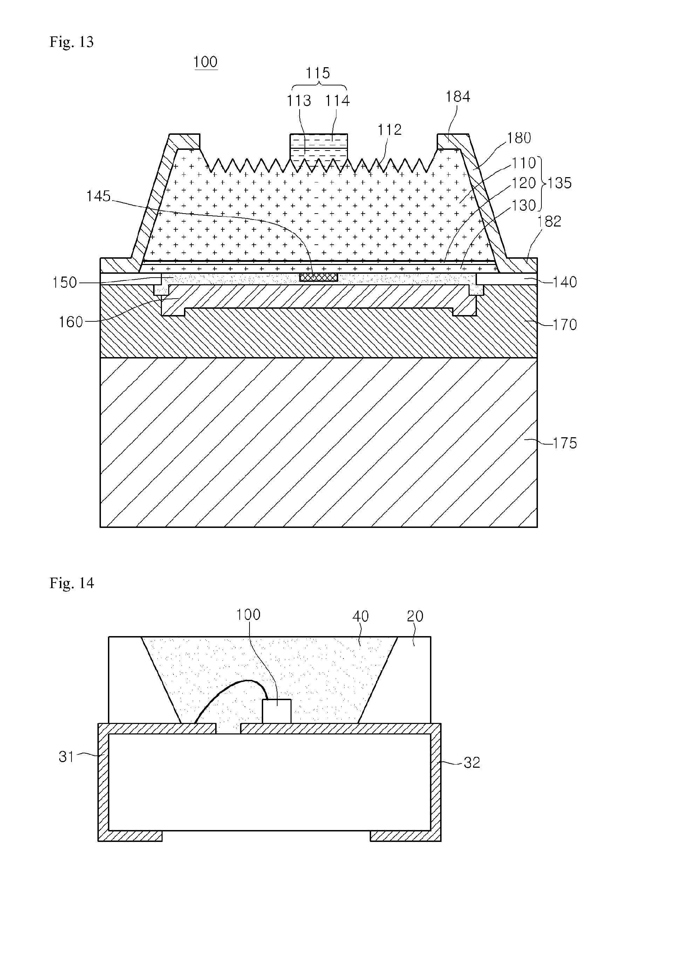

Referring to Fig. 13, a chip separation process for dividing the light emitting device of Fig. 12 into individual light emitting device units may be performed to provide the light emitting device 100 according to an embodiment.

For example, the chip separation process may comprise a breaking process in which a physical force is applied using a blade to separate a chip, a laser scribing process in which a laser is radiated onto a chip boundary to separate a chip, and an etching process comprising a wet or dry etching process, but is not limited thereto.

Fig. 14 is a sectional view of a light emitting device package comprising the light emitting device according to an embodiment.

Referring to Fig. 14, a light emitting device package according to an embodiment comprises a body 20, first and second electrode layers 31 and 32 disposed on the body 20, a light emitting device 100 disposed on the body 20 and electrically connected to the first and second electrode layers 31 and 32, and a molding member 40 surrounding the light emitting device 100.

The body 20 may be formed of a silicon material, a synthetic resin material, or a metal material. Also, an inclined surface may be disposed around the light emitting device 100.

The first and second electrode layers 31 and 32 are electrically separated from each other to supply a power to the light emitting device 100. Also, the first and second electrode layers 31 and 32 may reflect light generated in the light emitting device 100 to increase light efficiency. In addition, the first and second electrode layers 31 and 32 may dissipate heat generated in the light emitting device 100 to the outside.

The light emitting device 100 may be disposed on the body 20 or first or second electrode layer 31 or 32.

The light emitting device 100 may be electrically connected to the first and second electrode layers 31 and 32 through one of a wire bonding process, a flip chip process, and a die bonding method.

The molding member 40 may surround the light emitting device 100 to protect the light emitting device 100. Also, a phosphor may be comprised in the molding member 40 to change a wavelength of light emitted from the light emitting device 100.

A plurality of light emitting device packages according to an embodiment may be arrayed on a board. Optical members such as a light guide plate, a prism sheet, a diffusion sheet, and a fluorescence sheet may be disposed on a path of the light emitted from the light emitting device packages. The light emitting device packages, the board, and the optical members may be functioned as a backlight unit or a lighting unit. For example, a lighting system may comprise the backlight unit, the lighting unit, an indicating device, a lamp, and a street lamp.

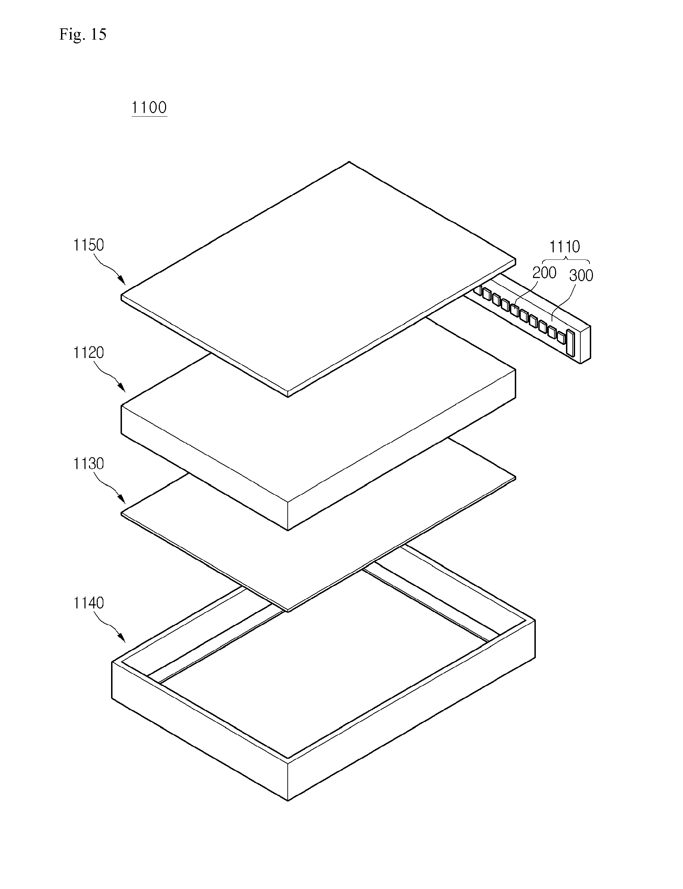

Fig. 15 is a view of a backlight unit comprising the light emitting device package according to an embodiment. However, the backlight unit of Fig. 15 is described as an example of the lighting system. Thus, the present disclosure is not limited thereto.

Referring to Fig. 15, the backlight unit 1100 may comprise a bottom frame 1140, a light guide member 1120 disposed within the bottom frame 1140, and a light emitting module 1110 disposed on at least one side or a bottom surface of the light guide member 1120. Also, a reflective sheet 1130 may be disposed under the light guide member 1120.

The bottom frame 1140 may have a box shape with an opened upper side to receive the light guide member 1120, the light emitting module 1110, and the reflective sheet 1130. The bottom frame 1140 may be formed of a metal material or a resin material, but is not limited thereto.

The light emitting module 1110 may comprise a board and a plurality of light emitting device packages mounted on the board. The plurality of light emitting device packages may provide light to the light guide member 1120.

As shown in Fig. 15, the light emitting module 1110 may be disposed on at least one of inner surfaces of the bottom frame 1140. Thus, the light emitting module 1110 may provide light toward at least one side surface of the light guide member 1120.

However, the light emitting module 1110 may be disposed under the bottom frame 1140 to provide light toward an bottom surface of the light guide member 1120. This may be variously modified according to a design of the backlight unit 1100, and thus, the present disclosure is not limited thereto.

The light guide member 1120 may be disposed within the bottom frame 1140. The light guide member 1120 may receive the light provided from the light emitting module 1110 to produce planar light, thereby guiding the planar light to a display panel.

For example, the light guide member 1120 may be a light guide panel (LGP). The LGP may be formed of one of a acryl resin-based material such as polymethylmethacrylate (PMMA), a polyethylene terephthalate (PET) resin, a poly carbonate (PC) resin, a cyclic olefin copolymer (COC) resin, and a polyethylene naphthalate (PEN) resin.

An optical sheet 1150 may be disposed above the light guide member 1120.

For example, the optical sheet 1150 may comprise at least one of a diffusion sheet, a light collection sheet, a brightness enhancement sheet, and a fluorescence sheet. For example, the diffusion sheet, the light collection sheet, the brightness enhancement sheet, and the fluorescence sheet may be stacked to form the optical sheet 1150. In this case, the diffusion sheet 1150 may uniformly diffuse light emitted from the light emitting module 1110, and the diffused light may be collected into the display panel by the light collection sheet. Here, the light emitted from the light collection sheet is randomly polarized light. The bright enhancement sheet may enhance a degree of polarization of the light emitted from the light collection sheet. For example, the light collection sheet may be a horizontal and/or vertical prism sheet. Also, the bright enhancement sheet may be a dual brightness enhancement film. The fluorescence sheet may be a light transmitting plate or film comprising a phosphor.

The reflective sheet 1130 may be disposed under the light guide member 1120. The reflective sheet 1130 reflects the light emitted through the bottom surface of the light guide member 1120 toward a light emission surface of the light guide member 1120.

The reflective sheet 1130 may be formed of a material having superior reflectance, e.g., a PET resin, a PC resin, or a PVC resin, but is not limited thereto.

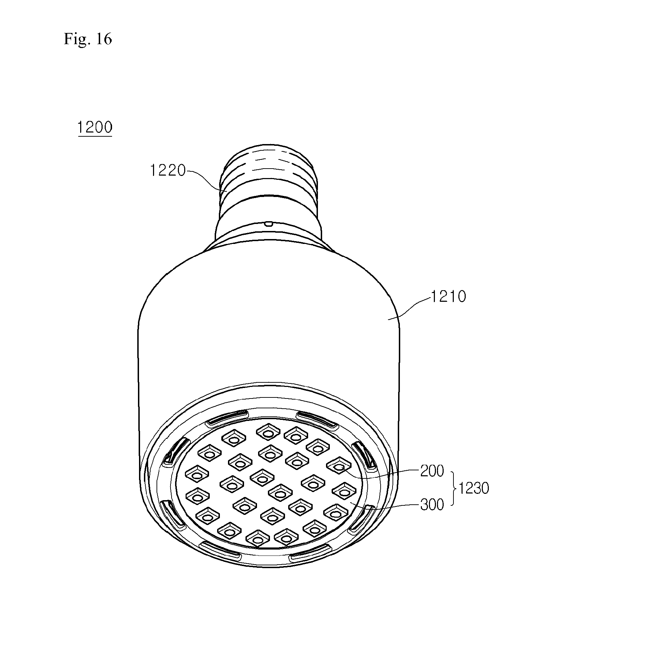

Fig. 16 is a perspective view of a lighting unit comprising the light emitting device package according to an embodiment. However, the lighting unit 1200 of Fig. 16 is described as an example of the lighting system. Thus, the present disclosure is not limited thereto.

Referring to Fig. 16, the lighting unit 1200 may comprise a case body 1210, a light emitting module 1230 disposed on the case body 1210, a connection terminal 1220 disposed on the case body 1210 to receive a power from an external power source.

The case body 1210 may be formed of a material having good thermal dissipation properties, e.g., a metal material or a resin material.

The light emitting module 1230 may comprise a board 300 and a light emitting device package 200 disposed on the board 300 and according to at least one embodiment.

The board may comprise a circuit pattern printed on a dielectric. For example, the board 300 may comprise a printed circuit board (PCB), a metal core PCB, a flexible PCB, and a ceramic PCB.

Also, the board 300 may be formed of a material which may effectively reflect light or have a color by which light is effectively reflected, e.g., a white color or a silver color.

The light emitting device package 200 according to at least one embodiment may be mounted on the board 300. The light emitting device package 200 may comprise at least one light emitting diode (LED). The LED may comprise colored LEDs, which respectively emit light having a red color, a green color, a blue color, and a white color and an ultraviolet (UV) LED emitting UV rays.

The light emitting module 1230 may have various combinations of the LED to obtain color impression and brightness. For example, the white LED, the red LED, and the green LED may be combined with each other to secure a high color rendering index. Also, a fluorescence sheet may be further disposed on a path of light emitted from the light emitting module 1230. The fluorescence sheet changes a wavelength of the light emitted from the light emitting module 1230. For example, when the light emitted from the light emitting module 1230 has a blue wavelength band, the fluorescence sheet may comprise a yellow phosphor. Thus, the light emitted from the light emitting module 1230 passes through the fluorescence sheet to finally emit white light.

The connection terminal 1220 may be electrically connected to the light emitting module 1230 to provide a power to the light emitting module 1230. Referring to Fig. 16, the connected terminal 1220 is screw-coupled to an external power source in a socket manner, but is not limited thereto. For example, the connection terminal 1220 may have a pin shape, and thus, be inserted into the external power source. Alternatively, the connection terminal 1220 may be connected to the external power source by a wire.

As described above, in the lighting system, at least one of the light guide member, the diffusion sheet, the light collection sheet, the brightness enhancement sheet, and the fluorescence sheet may be disposed on the path of the light emitted from the light emitting module to obtain a desired optical effect.

As described above, the lighting system according to the embodiments comprise the light emitting device package to improve reliability.

Embodiments may provide the light emitting device having a new structure, the method of fabricating the light emitting device, the light emitting device package, and the lighting system.

Embodiments may also provide the light emitting device having improved reliability, the method of fabricating the light emitting device, the light emitting device package, and the lighting system.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device comprising:
a light emitting structure layer comprising a first conductive type semiconductor layer, an active layer, and a second conductive type semiconductor layer;
a gallium barrier layer on the light emitting structure layer; and
a metal electrode layer on the gallium barrier layer.

2. The light emitting device according to claim 1, wherein the gallium barrier layer is a metal layer comprising gallium, and the metal electrode layer is formed of at least one of Cr, Ni, Au, Ti, and Al.

3. The light emitting device according to claim 2, wherein the gallium barrier layer comprises at least one of Al, Ti, Ta, Cr, Mn, V, Nb, Hf, Zr, and Zn.

4. The light emitting device according to claim 2, wherein the gallium barrier layer comprises Al and has a weight ratio of about 1 % to about 17% with respect to the Al.

5. The light emitting device according to claim 2, wherein the gallium barrier layer comprises Ti and has a weight ratio of about 1% to about 14% with respect to the Ti.

6. The light emitting device according to claim 2, wherein the gallium barrier layer comprises Ta and has a weight ratio of about 1% to about 14% with respect to the Ta.

7. The light emitting device according to claim 2, wherein the gallium barrier layer comprises Cr and has a weight ratio of about 1% to about 15% with respect to the Cr.

8. The light emitting device according to claim 2, wherein the gallium barrier layer comprises Mn and has a weight ratio of about 1% to about 10% with respect to the Mn.

9. The light emitting device according to claim 2, wherein the gallium barrier layer comprises V and has a weight ratio of about 1% to about 15% with respect to the V.

10. The light emitting device according to claim 2, wherein the gallium barrier layer comprises Nb and has a weight ratio of about 1% to about 5% with respect to the Nb.

11. The light emitting device according to claim 2, wherein the gallium barrier layer comprises Hf and has a weight ratio of about 0.3% to about 3% with respect to the Hf.

12. The light emitting device according to claim 2, wherein the gallium barrier layer comprises Zr and has a weight ratio of about 0.2% to about 1% with respect to the Zr.

13. The light emitting device according to claim 2, wherein the gallium barrier layer comprises Zn and has a weight ratio of about 0.5% to about 4% with respect to the Zn.

14. The light emitting device according to claim 1, wherein the first conductive type semiconductor layer is doped with an N-type dopant, a conductive support member is disposed under the second conductive type semiconductor layer, and at least one of an ohmic layer, a reflective layer, and an adhesion layer is disposed between the second conductive type semiconductor layer and the conductive support member.

15. A light emitting device package comprising:
a body;
first and second electrode layers disposed on the body; and
a light emitting device according to any one of claims 1 to 14 disposed on the body and electrically connected to the first and second electrode layers.
